Europäisches Patentamt

European Patent Office . (11) Publication number: **0 046 393**

Office européen des brevets A2

(19)

# EUROPEAN PATENT APPLICATION

(12)

(21) Application number: **81303730.6**

(22) Date of filing: **17.08.81**

(51) Int. Cl.³: **G 05 B 19/405**

---

(30) Priority: **20.08.80 JP 114475/80**

(43) Date of publication of application: **24.02.82**
**Bulletin 82/8**

(84) Designated Contracting States: **AT BE CH DE FR GB IT LI LU NL SE**

(71) Applicant: **FUJITSU FANUC LIMITED, 5-1, Asahigaoka, 3-chome, Hino-shi, Tokyo 191 (JP)**

(72) Inventor: **Imazeki, Ryoji, 987-44, Naganuma-cho, Hachioji-shi Tokyo, 192 (JP)**
Inventor: **Kurakake, Mitsuo, 3-3-10, Tamadaira Hino-shi, Izumi-Hights 103 Tokyo, 191 (JP)**

(74) Representative: **Billington, Lawrence Emlyn et al, HASELTINE LAKE & CO Hazlitt House 28 Southampton Buildings Chancery Lane, London WC2A 1AT (GB)**

---

(54) **Numerical control devices.**

㊼ A numerical controller equipped with a power source voltage diagnostic function, in which there are provided an A–D converter (AD) for converting into a digital quantity the output voltage from a DC power source used in the numerical controller and a processor (CPU) for reading out the output from the A–D converter (AD) to perform a predetermined operation for checking the power source voltage.

EP 0 046 393 A2

-1-
Numerical Control Devices

The present invention relates to numerical control devices.

In a shipping test, installation or trouble shooting of a numerical controller, it is usually necessary to check whether the output voltage value of each of DC power sources supplied to various circuits in the numerical controller is normal or not. In the prior art, however, the check is made using a measuring instrument such as a digital voltmeter, so that in case of emergency when such a measuring instrument is not available, for example, in case of trouble shooting, the check is difficult to make and consequently a malfunctioning point cannot be located at an early stage.

According to the present invention there is provided a numerical control device provided with power source diagnostic means comprising: an A-D converter for converting into a digital quantity an output voltage from a DC power source employed in or with the numerical control device when it is in use; and means operable to read-out said digital quantity from the A-D converter whereby the quantity may be checked.

A preferred embodiment provides a numerical controller which is designed to be able to diagnose each power source voltage by only an additional provision of a very small number of circuit elements so that the power source voltage may be checked without involving the use of a separately-provided measuring instrument.

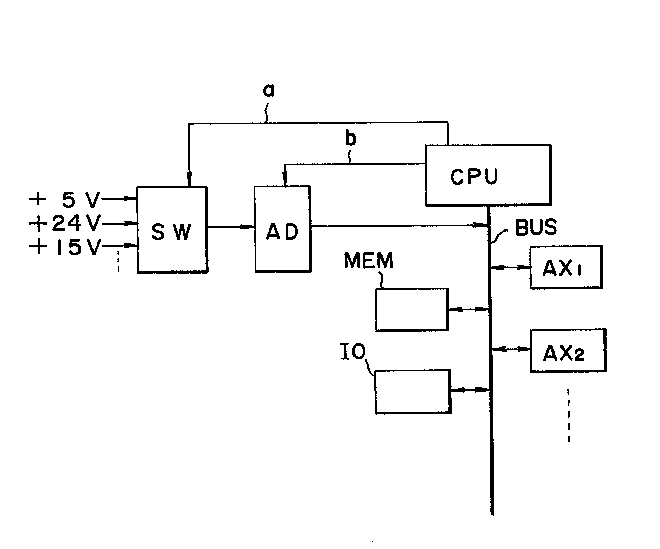

For a better understanding of the present invention and to show how it may be put into effect reference will now be made by way of example to the single figure of the accompanying drawing, which illustrates in block form the principal part of an embodiment of the present invention.

In the accompanying drawing, reference character CPU indicates a main processor; BUS designates a main bus; MEM identifies a main memory; IO denotes an NC operator panel; and $AX_1$ and $AX_2$ represent axis control circuits. As is well-known in the art, the main processor CPU follows a machining program loaded in the main memory MEM to process data from the memory MEM or the operator panel IO and to provide the results of processing via the main bus BUS to the axis control circuits $AX_1$ and $AX_2$, carrying out predetermined numerical control.

Reference character SW indicates a select switch; and AD designates an A-D converter. They are newly added according to the illustrated embodiment of the present invention.  The select switch SW is arranged so that it is supplied with output voltages +5V, +15V, +24V,... of various DC power sources employed in the numerical controller and that one of the inputs which is specified by a select signal $\underline{a}$ from the main processor CPU is provided to the A-D converter  AD of the next stage.  The A-D converter AD, when supplied with a read strobed signal $\underline{b}$ from the main processor CPU, converts the selected switch output into a digital quantity, which is provided on the main bus BUS of the main processor CPU.  The main processor CPU reads out the output data to execute or permit a predetermined power source voltage checking operation.

The operation by the main processor CPU is such, for example, as follows: For example,  the data read out are sequentially displayed on a display unit provided on the operator panel IO, enabling the operator to make a visual check.  Alternatively, or in addition, the data read out are compared by the processor with reference data prestored in the main memory MEM and the comparison results of this check are displayed on the NC operator panel IO.  Such a power source voltage checking operation may be performed not only on the off-line basis but also on the on-line basis when connecting the power source or for each period for the purpose of self-diagnosis.

While in the above the readout of the output from the A-D converter AD and the predetermined power source voltage checking operation are described possibly to be effected by the main processor CPU which performs data processing for numerical control, it is also possible to carry out such operations by another processor, for example, a microprocessor provided to share the main processor's load.

As will be appreciated from the foregoing, according to the described embodiment of the present invention, an A-D converter is provided for converting into digital form the output voltage of a DC power source used in the numerical controller and the A-D converter output may be read out by a processor and displayed on an NC operator panel, the processor performing or enabling to be performed a predetemined power source voltage checking operation. Accordingly, by additional provision of a very small number of circuit elements, the numerical controller can be equipped with the power source voltage diagnostic function. Therefore, the power source voltage can be diagnosed without using a special measuring instrument, so that the power source voltage can quickly be checked in case of emegency and an early detection of a malfunctioning point is also facilitated.

In recent years, a one-chip, high performance A-D converter which, for example, has eight channels of analog inputs, provides a 10-bit output and has a conversion rate of several $\mu$s, is easily available at low cost. By using such an A-D converter in an embodiment of the present invention, the A-D conversion unit including the select switch SW is formed by one chip, permitting further simplification and economization of the overall circuit arrangement.

It will be apparent that many modifications and variations may be effected without departing from the scope of the novel concepts of this invention.

0046393

Claims:

1.     A numerical control device which is provided with
power source diagnostic means comprising: an A-D
converter for converting into a digital quantity an
output voltage from a DC power source employed in or
with the numerical control device when it is in use;
and means operable to read-out said digital quantity
from the A-D converter whereby the quantity may be
checked.

2.     A numerical control device according to claim
1, wherein said means operable to read-out said digital
quantity comprises a processor.

3.     A numerical control device according to claim 2,
wherein said processor is operable to perform a
predetermined power source voltage checking operation.

4.     A numerical control device according to claim 2
or 3, wherein said processor is a main processor having
the main function of data processing for numerical
control.

5.     A numerical control device according to claim 2 or
3, wherein said processor is a microprocessor provided
to share the load of a main processor having the
function of data processing for numerical control.

6.     A numerical control device according to any
one of the preceding claims  3, or 3 and 4, or 3 and
5, wherein said processor is coupled to a visual
display unit for displaying to a human operator the result
of a checking operation.

7.      A numerical control device according to any preceding claim, wherein said means operable to read-out said digital quantity comprises a visual display unit enabling a human operator to check said digital quantity.

8.      A numerical control device according to any preceding claim, wherein the power source diagnostic means comprises a multi-input selector switch connected before the A-D convertor, having a plurality of inputs for connection to the outputs of respective ones of a plurality of DC power sources.

9.      A numerical controller equipped with a power source voltage diagnostic function, comprising:

an A-D converter for converting into a digital quantity the output voltage from a DC power source used in the numerical controller; and

a processor for reading out the output from the A-D converter to perform a predetermined power source voltage checking operation.

10.      A numerical control device according to any one of the preceding claims, in combination with one or more DC power sources as aforesaid.